# EUROPÄISCHE PATENTSCHRIFT

(11) **EP 3 552 468 B1**
(45) Veröffentlichungstag und Bekanntmachung des Hinweises auf die Patenterteilung: **13.10.2021**
(21) Anmeldenummer: 17794278.6
(22) Anmeldetag: 24.10.2017
(51) Int. Cl.: H05K 7/20, H04B 15/02, H05K 7/14, H04B 1/036

(54) **EMV-KÜHLGERÄT**
EMC COOLING DEVICE
APPAREIL DE REFROIDISSEMENT CEM

(30) Priorität: 12.12.2016 DE 102016124099
(43) Veröffentlichungstag der Anmeldung: 16.10.2019
(73) Patentinhaber: EBM-Papst Mulfingen GmbH&CO. KG, 74673 Mulfingen (DE)
(72) Erfinder: ECCARIUS, Michael, 74673 Mulfingen-Jagstberg (DE); HAAS, Günter, 74673 Mulfingen (DE)
(74) Vertreter: Staeger & Sperling Partnerschaftsgesellschaft mbB
(86) Internationale Anmeldenummer: PCT/EP2017/077047
(87) Internationale Veröffentlichungsnummer: WO 2018/108367

(56) Entgegenhaltungen:
- DE-A1-102011 084 942
- DE-U1-202006 019 141

## Beschreibung

Die Erfindung betrifft eine Kühlvorrichtung mit den Merkmalen von Anspruch 1.

Die Abschirmung elektrotechnischer Geräte, Einrichtungen und Räume dient dazu, elektrische und/oder magnetische Felder von diesen fernzuhalten oder umgekehrt die Umgebung der Geräte vor den von der Einrichtung ausgehenden Feldern zu schützen. Die Europäische EMV-Richtlinie definiert hierbei elektromagnetische Verträglichkeit als "die Fähigkeit eines Apparates, einer Anlage oder eines Systems, in der elektromagnetischen Umwelt zufriedenstellend zu arbeiten, ohne dabei selbst elektromagnetische Störungen zu verursachen, die für die in dieser Umwelt vorhandenen Apparate, Anlagen oder Systeme unannehmbar wären".

Elektromagnetische Wellen als solche, die sowohl eine magnetische als auch eine elektrische Komponente besitzen, müssen ebenfalls häufig abgeschirmt werden, um deren Abstrahlung oder Einstrahlung zu verhindern oder zu verringern.

Die Wirkung einer Abschirmung wird über die Schirmdämpfung quantifiziert. Bei Leitungsschirmen ist die Messgröße der Schirmwirkung die Transferimpedanz.

Es geht bei der EMV im Kern um drei wesentliche Themen: eine Einrichtung beeinflusst die Umwelt, die Umwelt beeinflusst die Einrichtung und Komponenten innerhalb einer Einrichtung beeinflussen sich gegenseitig über Kopplungsmechanismen, wie Impedanz-Kopplung, kapazitive- und induktive Strahlungsüberlagerung. Die Ursache für eine induktive Kopplung ist ein magnetisches Wechselfeld. Um einen stromdurchflossenen Leiter bildet sich ein Magnetfeld aus, das auch benachbarte Leiter und Vorrichtungen durchdringt. Eine Stromänderung bewirkt auch eine Änderung des Magnetfeldes, wodurch dann eine Spannung in den benachbarten elektrisch leitfähigen Komponenten induziert wird.

Die Störgröße der kapazitiven Kopplung ist die elektrische Spannung selbst. Zwischen zwei benachbarten Leitern unterschiedlichen elektrischen Potentials - etwa Starkstrom- und Signalleitern - tritt kapazitive Kopplung auf. Die Leitungen stellen im weitesten Sinne Kapazitäten dar. Durch das elektrische Feld werden über diese parasitären Koppelkapazitäten Ladungen von einem Stromkreis zum anderen verschoben. Die Koppelkapazität ist direkt proportional zur Länge der parallel geführten Leitungen und verringert sich mit wachsendem Abstand zwischen den Leitern.

Es werden Einwirkungen durch elektrische oder magnetische Felder, Einwirkungen durch elektromagnetische Wellen, sowie leitungsgebundene Einwirkungen zu unterscheiden. Außerdem sind je nach Einsatzgebiet weitere umfangreiche nationale und internationale Normen und Vorschriften zu beachten. Die aktuellen Trends zu immer mehr drahtloser Kommunikation, weiter fortschreitender Miniaturisierung, sowie Digitalisierung bei immer höheren Taktraten verschärfen die Problematik der EMV-Verträglichkeit.

Im Stand der Technik gibt es diverse Lösungsansätze solche EMV-Störungen zu reduzieren. So können rein leitungsgebundenen Störungen häufig mit geeigneter Masseführungen oder durch Potentialausgleich beseitigt oder mit Kabelschirmen und mit Filtern abgeholfen werden. Die gängigste und wirkungsvollste Maßnahme gegen elektromagnetische Beeinflussung ist ein Faraday'scher Käfig, der am einfachsten durch ein metallisches oder leitfähiges Gehäuse realisiert werden kann. Die Verringerung der induktiven Einkopplung geschieht durch benachbarte Verlegung von Hin- und Rückleitern, also Minimierung der aufgespannten Fläche (kleinere unsymmetrische Störungen), Verlegung der Leiter direkt an der Massestruktur (kleinere unsymmetrische Störungen), Stromänderungen verkleinern, Vermeidung von Parallelführung leitungsverschiedener Kreise, Vermeidung großer Leiterschleifen und die Auswahl geeigneter Materialien für niederfrequente und hochfrequente Bereich.

Die Verringerung der kapazitiven Einkopplung geschieht durch Maximierung des Abstandes der Leiter zueinander, durch dichte Verlegung der Leitung an die Massestruktur, durch Verwendung geschirmter Kabel, durch Einfügen statischer Schirme (Masseflächen) und durch räumliche Trennung von empfindlichen und störbehafteten Kreisen.

Die zuvor genannten Maßnahmen laufen allerdings dem allgemeinen Trend entgegen, dass elektrische Anlagen zunehmend skalierbare und modular aufgebaut sein und auch zunehmend kompakter gebaut werden sollen.

Speziell bei Kühlgeräten stellt sich das Problem, dass innerhalb nur einer einzigen Einhausung in der Regel mehrere elektrisch arbeitende Maschinen untergebracht werden müssen. Ein solches beispielhafte Kühlgerät ist in der DE 10 2015 108 910 A1 offenbart.

Ein derartiges gattungsbildendes Kühlgerät gemäß der DE 10 2015 108 910 A1 weist häufig einen ersten Lüfter für die Durchströmung eines ersten Wärmetauschers mit Schaltschrankluft und einen zweiten Lüfter für die Durchströmung eines zweiten Wärmetauschers mit Umgebungsluft auf.

Aus dem Stand der Technik sind Kühlgeräte bekannt, bei denen die elektrischen Komponenten hinsichtlich der Versorgungsspannung bzw. Netzspannung am Einsatzort angepasst sind. So ist es im Stand der Technik üblich, für jede gewünschte Leistungsstufe eines Kühlgeräts jeweils eine spezifische Variante für eine Netzspannung von 115 V, 230 V und für 400 V sowie diverse Sonderspannungen bereit zu stellen. Auf diese Weise wird eine weitgehend weltweite Nutzung ermöglicht.

Je nach lokal vorhandener Netzspannung kann beispielsweise ein entsprechender Transformator mit einem Primäreingang von 115 V, 200, 230 V, 400 V oder 460 V verwendet werden, wobei dies dann je nach Primäreingangsspannung etwa eine Sekundärausgangsspannung von 230 V, 400 V oder 460 V bei diversen Leistungen bereitstellt. Je nach Sekundärausgangsspannung des Transformators weist das Kühlgerät einen Controller auf, der bei der jeweiligen Sekundärausgangsspannung des Transformators betrieben wird und mit entsprechenden Spannungen die regelbaren elektrischen Bauteile des Kühlgeräts ansteuert.

Dieser Umstand erfordert wiederum, dass auch diese von dem Controller angesteuerten Komponenten je nach lokalem Einsatzgebiet des Kühlgeräts in einer darin angepassten Spannungsvariante von z. B. 115 V, 200 V, 230 V, 400 V oder 460 V bereitgestellt werden müssen.

Aus dem Stand der Technik sind auch Kühlgeräte bekannt, bei denen die aktiven Gerätekomponenten direkt über einen Transformator mit einer angepassten Spannung betrieben werden.

Um Kühlgeräte der gattungsgemäßen Art in einer Bauform für die verschiedenen unterschiedlichen Netzspannungen bereitzustellen, wird im Stand der Technik vorgeschlagen eine Spannungsversorgung mit einem Aufwärts- und/oder Abwärtswandler zu koppeln, der über einen Gleichrichter mit einem Weitbereichseingang für ein- oder mehrphasige Wechselspannung verbunden ist und einen Kondensator auf eine Zwischenkreisspannung auflädt, die oberhalb oder unterhalb einer an dem Weitbereichseingang anliegenden Netzspannung liegt, wobei ein Netzteil mindestens eines der beiden Lüfter parallel zu dem Kondensator geschaltet ist.

Um unabhängig von einer an dem Weitbereichseingang anliegenden Eingangswechselspannung einen Verdichter eines Kühlgerätes mit einer für eine bestimmte Verdichterleistung benötigten Nenndrehspannung zu betreiben, ist zur Leistungsvariation des Verdichters der Drehstromwechselrichter darauf ausgelegt ist, die Nenndrehspannung in Abhängigkeit der benötigten Verdichterleistung entweder anzuheben oder abzusenken.

Der Betrieb dieser Kühlgeräte wird typischerweise mittels Gleichrichten und Anheben und/oder Absenken Eingangswechselspannung auf eine konstante Zwischenkreisgleichspannung realisiert sowie Zuführen der Zwischenkreisgleichspannung an ein Netzteil des Lüfters oder der vorhandenen Lüfter, wobei die Zwischenkreisgleichspannung so bemessen ist, dass über das Netzteil eine Netzteilspannung bereitgestellt werden kann, die für den Betrieb der Lüfter erforderlich ist.

Nachteilig bei einer solchen Lösung innerhalb einer vorzugsweise umhausten Bauform ist der Umstand, dass sich bereits bauartbedingt EMV-Probleme ergeben, die insbesondere durch die Mehrzahl an eingesetzten strahlungsemittierenden elektrischen Einrichtungen durch zumindest galvanische und, oder kapazitive und/oder induktive und, oder strahlungsüberlagernde Kopplungseffekte elektromagnetische Gesamtfeldverstärkungen auftreten. Ferner verschlechtern sich die Bedingungen für Einhausungs- und Abschirmungsgegenmaßnahmen durch den konstruktiven Zwang zur Aufnahme einer Vielzahl elektromagnetfeldemittierender Maschinen oder Komponenten und lassen sich die bekannten Maßnahmen zur Änderung von Strom und Spannung bei den Betriebsanforderungen der Vielzahl von elektrisch arbeitenden Einheiten kaum realisieren.

Aus den Druckschriften DE 20 2006 019141 U1 und DE 10 2011 084942 A1 sind Offenbarungen bekannt, die sich mit der Unterdrückung von Störsignalen beschäftigen.

Der Erfindung liegt deshalb die Aufgabe zugrunde, vorbesagte Nachteile zu überwinden und eine Kühlvorrichtung bereitzustellen, welche verbesserte EMV-Eigenschaften aufweist bei gleichzeitiger Reduktion der Anzahl der Benötigten Bauteile und/oder Elemente.

Diese Aufgabe wird durch die Merkmalskombination gemäß Patentanspruch 1 gelöst.

Erfindungsgemäß konnte erkannt werden, dass durch geschickte und gezielte Auswahl der elektrisch arbeitenden Maschinen und Einheiten und somit der elektromagnetfeldemittierenden Bauteile sowie der Reduktion der Anzahl benötigter Bauteile innerhalb einer gattungsgemäßen Kühlvorrichtung die EMV Eigenschaften der Kühlvorrichtung verbessert.

Ein Grundgedanke ist dabei, die Versorgung der elektrischen Einheiten, die jeweils Lüfter, insbesondere Innenlüfter und Außenlüfter sind, welche ohne Netzteil ausgebildet sind, nicht über gesonderte Netzteile vorzunehmen, sondern unmittelbar aus dem Zwischenkreis oder dem Wechselrichter eines Frequenzumrichters zu speisen. Auf diese Weise können sowohl Kosten für Bauteile und Zusatzmaßnahmen zur Abschirmung reduziert werden. Ein weiterer Vorteil besteht in der Erhöhung der Betriebssicherheit durch Wegfall der Einflüsse der EMV-Belastung auf solche Bauteile.

Optional wird daher vorgesehen, dass der wenigstens eine Ventilator mit der von extern zugeführten und gleichgerichteten Versorgungsspannung aus dem Frequenzumrichter direkt betrieben wird und derart in das Kühlgerät integrierbar ist, dass der oder die Ventilatoren reversibel in das Kühlgerät aufnehmbar und austauschbar sind.

Auf diese Weise kann der wenigstens eine Ventilator modulartig und austauschbar je nach Kälteaufgabe in das Kühlgerät integriert sein, sodass der jeweilige Ventilator an den weiteren nachfolgend beschriebenen EMVreduzierenden Maßnahmen partizipiert bzw. berücksichtigt wird.

Ein weiterer Gedanke der Erfindung besteht darin, die leitungsgebundenen und/oder feldgebundenen Störungen durch die noch verbleibenden Störquellen, insbesondere die dynamischen Störungen mittels Kompensation zu reduzieren. Hier nutzt man den Effekt der Strahlungsüberlagerungen bei mehreren Störquellen derart, dass die resultierende Strahlung hinsichtlich Amplitude und/oder Frequenz reduziert ist. Im Folgenden wird auf die dem Fachmann geläufigen Begriffe in diesem Zusammenhang zurückgegriffen.

So beschreibt der Störpegel diejenige Größe(n), die zur Quantifizierung der EMV-Störung herangezogen werden. Die zulässige Störaussendung wird innerhalb der EU durch die Schutzanforderungen der EMV-Richtlinie im Detail geregelt, die auf entsprechende Normen verweist. Diese Normen enthalten die konkreten Grenzwerte von Störpegeln für bestimmte Frequenzbereiche, Gerätekategorien und Umgebungen. Die elektromagnetische Störfestigkeit bezeichnet die gewünschte Resistenz eines zu prüfenden Systems, bis zu einem bestimmten Störpegel gegenüber einer Störquelle ungestört arbeiten zu können. Die Störfestigkeit lässt sich nicht generell durch einen isolierten Wert ausdrücken, sondern sie ist von einer Reihe von Parametern vor der Messung zu definieren, um dann nach der Messung quantitativ erkennen zu können, ob der Störpegel einen definierten Grenzwert überschreitet.

Besonders vorteilhaft eignet sich zur Ermittlung der Störfestigkeit die frequenzabhängige Störfestigkeit in Volt/Meter mit einer Amplitudenmodulation. Im Sinne der vorliegenden Erfindung wird eine Einheit als EMV-störungsfest bezeichnet, wenn während der Beaufschlagung der Einheit mit einer Störgröße eines bestimmten Störpegels, diese zwar eine Fehlfunktion zeigt, aber danach ohne äußeren Eingriff nach einer definierten Zeitspanne von z. B. 2 Sekunden selbständig wieder in seinen normalen Zustand zurückkehrt.

Unter Störkompensation im Sinne der vorliegenden Erfindung versteht man die Kompensation einer Feldstörung mittels eines Gegenfeldes, um mittels destruktiver Interferenz die Störung auszulöschen oder zu kompensieren, so dass durch ein Signal mit einer bestimmten Frequenz und Amplitude oder Polarität, durch ein Signal mit entgegengesetzter Amplitude oder Polarität, aber gleicher Frequenz kompensiert werden kann.

Erfindungsgemäß wird daher eine Kühlvorrichtung umfassend eine metallische und/oder elektrisch leitfähige EMV-Einhausung vorgesehen, mit einem Frequenzumrichter (vorzugsweise FrequenzFrequenzumrichter) sowie mehrere elektrisch betriebene Einheiten oder Arbeitsmaschinen innerhalb der EMV-Einhausung, die ausgebildet sind eine lokale Temperatur in wenigstens einem Bereich innerhalb oder außerhalb der EMV-Einhausung zu beeinflussen, wobei der Frequenzumrichter wenigstens eine oder mehrere der Einheiten (z. B. Lüfter) mit einer jeweiligen Versorgungsspannung unmittelbar versorgt.

Der Frequenzumrichter und die elektrischen Einheiten oder Arbeitsmaschinen sind mit Vorteil jeweils so ausgebildet sind, dass die von dieser Einheit im Betrieb der Kühlvorrichtung spezifisch erzeugten leitungsgebundenen und/oder feldgebundenen Störungen durch eine leitungsgebundene und/oder feldgebundene Störung wenigstens einer der jeweils anderen Einheiten teilweise oder vollständig in ihrem jeweiligen Störpegel kompensiert wird.

Erfindungsgemäß ist vorgesehen, dass wenigstens eine oder mehrere der Einheiten Lüfter, insbesondere Innenlüfter und Außenlüfter sind.

Weiter bevorzugt ist es, wenn der wenigstens eine Lüfter durch einen anderen Lüfter reversibel austauschbar in der Kühlvorrichtung angebracht ist und der jeweils aktuell eingebaute Lüfter mit einer Versorgungsspannung aus einem Gleichstrom-Zwischenkreis des Frequenzumrichters direkt gespeist wird, so dass ein Netzteil für den jeweiligen Lüfter nicht erforderlich ist. Besonders vorteilhaft ist es, wenn der Frequenzumrichter an seinen Spannungsausgängen diverse Spannungslevel bereitstellen kann, so dass je nach Bestimmungsort der Kühlvorrichtung und der ausgewählten Ventilatoren, ein flexibler Einsatz möglich ist. Der Frequenzumrichter kann bevorzugt auch an unterschiedlichen Eingangsspannungen betrieben werden und kann dann jeweils eine konstante Ausgangsspannung erzeugen, an der die vorrichtungsinternen Spannungskonsumenten betreibbar sind.

In einer weiteren bevorzugten Ausgestaltung der Erfindung ist vorgesehen, dass wenigstens eine der weiteren Einheiten ein Kältekompressor ist. Mit Vorteil wird der Kältekompressor von einer Versorgungsspannung des Wechselrichters des Frequenzumrichters gespeist wird.

Bevorzugt ist ferner vorgesehen, dass wenigstens diejenige leitungsgebundene und/oder feldgebundene Störung mit dem höchsten Störpegel (bei einer bestimmten Frequenz oder über einen bestimmten Frequenzbereich hinweg) durch wenigstens eine leitungsgebundene und/oder feldgebundene Störung einer der anderen Einheiten oder auch des Frequenzumrichters so stark kompensiert wird, dass der daraus resultierende (frequenzabhängige) Störpegel unterhalb eines spezifischen Störfestigkeitspegels des oder der jeweils anderen Einheiten liegt. Durch eine solche geschickte Störgrößenkompensation mittels entsprechend ausgebildeten elektrischen Einheiten, kann insgesamt eine Reduktion der EMV-Störanfälligkeit erzielt werden und kann ferner sichergestellt werden, dass in dem System nur noch Störfelder oder EMV-Störungen unterhalb des Wertes derjenigen Einheit liegt, die die geringste Störfestigkeit in dem besagten Frequenzbereich aufweist.

In einer weiteren bevorzugten Ausgestaltung der Erfindung ist daher vorgesehen, dass der Frequenzumrichter und die Einheiten so gewählt und konfiguriert sind, dass ein oder mehrere der jeweiligen Störpegel der leitungsgebundenen und/oder feldgebundenen Störungen, die der Frequenzumrichter bzw. die Einheiten bei einem isolierten Einzelbetrieb erzeugen, in der in der Kühlvorrichtung implementierten Konfiguration kompensiert werden und zwar vorzugsweise in einem Maß unter den Störfestigkeitspegel derjenigen Einheit die im Vergleich zu den anderen Einheiten die geringste Störfestigkeit aufweist.

Erfindungsgemäß ist es vorgesehen, dass die jeweilige Kompensation der leitungsgebundenen und/oder feldgebundenen Störungen mittels einer destruktiven Interferenz oder Überlagerung der daran beteiligten Störungen erfolgt.

Erfindungsgemäß kann ferner eine Steuervorrichtung oder Steuerung vorgesehen werden, um die leitungsgebundenen und/oder feldgebundenen Störungen beim Betrieb der Kühlvorrichtung so in ihrer Störcharakteristik zu verändern oder anzupassen, dass dadurch die Überlagerung zweier oder mehrere der veränderten leitungsgebundenen und/oder feldgebundenen Störungen eine Störkompensation unterhalb eines definierten Störpegels erfolgt. Diese Maßnahme kann insbesondere frequenzabhängig durchgeführt werden.

Weiter vorteilhaft ist es, wenn die Anzahl der verwendeten Störquellen reduziert wird indem mehrere oder alle elektrisch betriebenen Einheiten ohne Netzteil ausgebildet sind und zur Spannungsversorgung lediglich mit dem Frequenzumrichter verbunden sind.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine schematische Ansicht einer erfindungsgemäßen Kühlvorrichtung und
- Fig. 2: eine schematische Darstellung einer Störfeldkompensation.

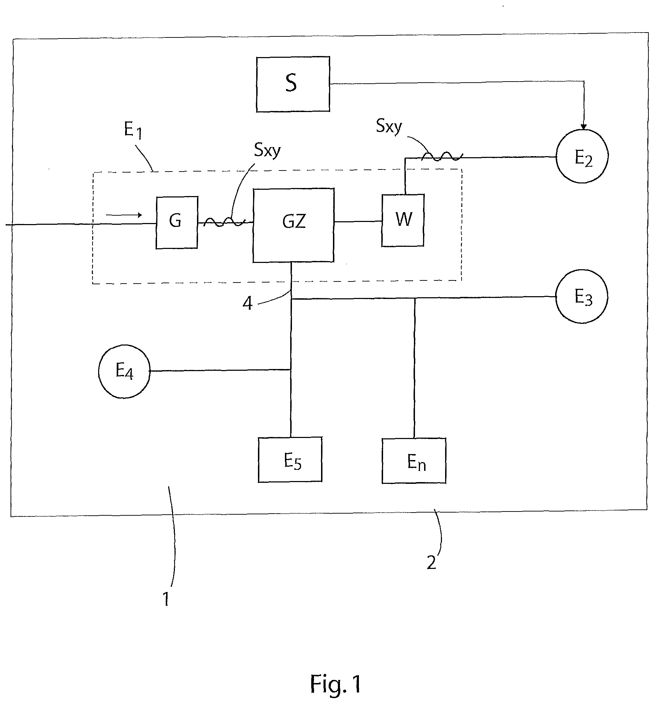

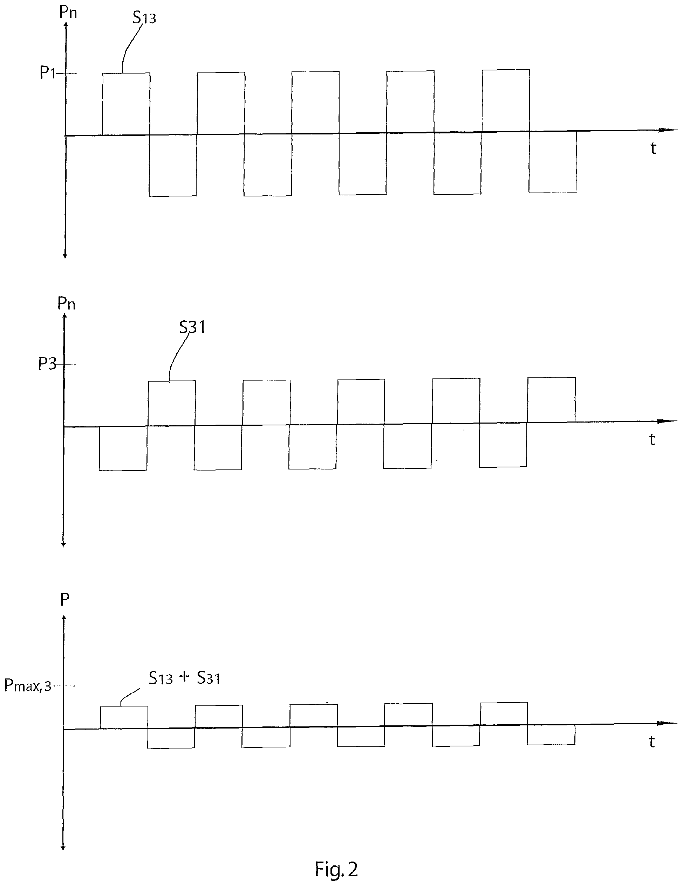

Im Folgenden wird die Erfindung anhand eines Ausführungsbeispiels mit Bezug auf die Figuren 1 und 2 näher erläutert, wobei gleiche Bezugszeichen auf gleiche funktionale und/oder strukturelle Merkmale hinweisen.

Die Figur 1 zeigt ein exemplarisches Ausführungsbeispiel einer Kühlvorrichtung 1 umfassend eine metallische und demnach leitfähige EMV-Einhausung 2. In der Einhausung 2 sind ein Frequenzumrichter E₁ sowie mehrere elektrisch betriebene Einheiten E₂, E₃, E₄, E₅ aufgenommen, die nachfolgend noch näher beschrieben werde. Im Betrieb der Kühlvorrichtung 1 erzeugt der Frequenzumrichter E₁ eine spezifische feldgebundene Störung S_{xy}, wobei xy hier eine Paarung jeweils aus der Störquelle und der Störsenke repräsentiert.

Dies bedeutet bei xy = 12, dass z. B. eine Störung S₁₂ eine solche EMV-Störung ist, die vom FrequenzFrequenzumrichter E₁ auf die Einheit E₂ wirkt.

In dem vorliegenden Beispiel umfasst Frequenzumrichter E₁ einen Gleichrichter G, eine Gleichstromzwischenkreis GZ und einen Wechselrichter W. Der Gleichstromzwischenkreis GZ ist mit einem Leistungsfaktorkorrekturfilter PFC ausgestattet.

Die Einheiten E₃, E₄, stellen Lüfter dar und zwar einen Innenlüfter E₃ und einen Aussenlüfter E₄. Die Einheit E₅ steht repräsentativ für eine beispielhafte weitere elektrisch betriebene Komponente, wie einer Heizung, einer Kondensatverdunstung oder dergleichen.

Die Einheit E₂ stellt einen Kompressor dar, der von einer Versorgungsspannung des Wechselrichters W des Frequenzumrichters E₁ versorgt wird.

Der Gleichstromzwischenkreis GZ verfügt über einen Spannungsabgriff 4 für jeweils die Einheiten E₃, E₄, E₅. Die Kühlvorrichtung 1 ist dabei so ausgebildet, dass die Lüfter E₃, E₄ durch einen anderen montagekompatiblen Lüfter reversibel austauschbar in der Kühlvorrichtung angebracht sind.

Der Frequenzumrichter E₁ und die Einheiten E₂, E₃, E₄, E₅ sind jeweils so ausgebildet, dass die von der jeweiligen Komponente im Betrieb der Kühlvorrichtung 1 spezifisch erzeugte leitungsgebundene und/oder feldgebundene Störung S_{xy} durch eine leitungsgebundene und/oder feldgebundene Störung S_{xy} wenigstens einer der jeweils anderen Komponenten teilweise oder vollständig in ihrem jeweiligen Störpegel Pn kompensiert wird, wie dies schematisch in der Figur 2 gezeigt ist.

Die Figur 2 zeigt eine exemplarische (aus Vereinfachungsgründen als Rechtecksignal dargestellte) Störung S13 vom Frequenzumrichter E1 mit einem ersten Störpegel P1 und eine diese Störung (aus Vereinfachungsgründen als Rechtecksignal dargestellte) kompensierende Störung S31 des Innenlüfters E3 mit einem Störpegel P3. Durch destruktive Interferenz der Störsignale S13 und S31, wie in der unteren Ansicht der Figur 2 gezeigt, wird die Störung bis auf die Differenz der Beträge der Störpegelmaxima P1, P3 kompensiert, wobei der Störfestigkeitspegel P_{max,3} des Innenlüfters E₃ den im Vergleich zu den anderen Einheiten geringsten Störfestigkeitspegel aufweist. Der Störpegel nach der Kompensation ist demnach geringer als der Störfestigkeitspegel P_{max,3} des Innenlüfters E₃.

Optional kann ferner eine Steuervorrichtung S vorgesehen sein, um die leitungsgebundenen und/oder feldgebundenen Störungen S_{xy} beim Betrieb der Kühlvorrichtung 1 so in ihrer Störcharakteristik zu verändern, dass durch die Überlagerung zweier oder mehrere der veränderten leitungsgebundenen und/oder feldgebundenen Störungen S_{xy} eine Störkompensation unterhalb eines definierten Störpegels erfolgt.

Die Erfindung beschränkt sich in ihrer Ausführung nicht auf die vorstehend angegebenen bevorzugten Ausführungsbeispiele. Vielmehr ist die Erfindung durch die angehängten Ansprüche definiert.

## Patentansprüche

1. Kühlvorrichtung (1) umfassend eine metallische und/oder elektrisch leitfähige EMV-Einhausung (2) und einen Frequenzumrichter (E₁) sowie mehrere elektrisch betriebene Einheiten (E_{2,...,} Eₙ) innerhalb der EMV-Einhausung (2), die jeweils ohne Netzteil ausgebildet sind und zur Spannungsversorgung lediglich mit dem Frequenzumrichter (E1) verbunden sind und wobei die Einheiten (E₂,..., En) ausgebildet sind eine lokale Temperatur in wenigstens einem Bereich (30, 31) innerhalb oder außerhalb der EMV-Einhausung (2) zu beeinflussen, wobei der Frequenzumrichter (E₁) wenigstens eine oder mehrere der Einheiten (E₂,..., En) mit einer jeweiligen Versorgungsspannung unmittelbar versorgt und wobei der Frequenzumrichter (E₁) und die Einheiten (E₂,..., En) jeweils so ausgebildet sind, dass die von dem Frequenzumrichter (E1) oder einer Einheit der Einheiten (E₂,..., En) im Betrieb der Kühlvorrichtung (1) spezifisch erzeugten leitungsgebundene und/oder feldgebundene Störung (S_{xy}) durch eine leitungsgebundene und/oder feldgebundene Störung (S_{xy}) wenigstens einer der jeweils anderen Einheiten (E_{1,...,} Eₙ) teilweise oder vollständig in ihrem jeweiligen Störpegel (Pₙ) kompensiert wird, **dadurch gekennzeichnet, dass** die Kompensation dabei durch eine destruktive Interferenz oder Überlagerung erfolgt, wobei wenigstens eine oder mehrere der Einheiten (E₂,..., Eₙ) Lüfter, insbesondere Innenlüfter und Außenlüfter sind.

2. Kühlvorrichtung (1) gemäß Anspruch 1, **dadurch gekennzeichnet, dass** die Kühlvorrichtung so ausgebildet ist, der wenigstens eine Lüfter (E₂,..., En) durch einen anderen Lüfter (E₂,..., En) reversibel austauschbar in der Kühlvorrichtung angebracht ist und der jeweils eingebaute Lüfter (E₂,..., En) mit einer Versorgungsspannung aus einem Gleichstrom-Zwischenkreis (GZ) des Frequenzumrichters (E₁) direkt gespeist wird.

3. Kühlvorrichtung (1) gemäß Anspruch 1, **dadurch gekennzeichnet, dass** wenigstens eine der Einheiten (E₂,..., En) ein Kältekompressor ist.

4. Kühlvorrichtung (1) gemäß Anspruch 2, **dadurch gekennzeichnet, dass** der wenigstens ein Kältekompressor von einer Versorgungsspannung eines Wechselrichters (W) des Frequenzumrichters (E₁) gespeist wird.

5. Kühlvorrichtung (1) gemäß einem der vorhergehenden Ansprüche, **dadurch gekennzeichnet, dass** wenigstens diejenige leitungsgebundene und/oder feldgebundene Störung (S_{xy}) mit dem höchsten Störpegel (Pn) durch wenigstens eine leitungsgebundene und/oder feldgebundene Störung (S_{xy}) einer der Einheiten (E₂,..., Eₙ) oder des Frequenzumrichters (E₁) so stark kompensiert wird, dass der daraus resultierende Störpegel (P_{n'}) unterhalb eines spezifischen Störfestigkeitspegels (Pₘₐₓ) des oder der jeweils anderen Einheiten (E₂,..., En) liegt.

6. Kühlvorrichtung (1) gemäß einem der vorhergehenden Ansprüche, **dadurch gekennzeichnet, dass** der Frequenzumrichter (E₁) und die Einheiten (E₂,..., Eₙ) so gewählt sind, dass ein oder mehrere der jeweiligen Störpegel (Pn) der leitungsgebundenen und/oder feldgebundenen Störungen (S_{xy}), die der Frequenzumrichter (E₁) bzw. die Einheiten (E₂,..., Eₙ) bei einem isolierten Einzelbetrieb erzeugen, in der in der Kühlvorrichtung (1) implementierten Konfiguration kompensiert werden vorzugsweise unter den Störfestigkeitspegel (P_{max,n}) derjenigen Einheit die im Vergleich zu den anderen Einheiten den geringsten Störfestigkeitspegel (P_{max,n}) aufweist.

7. Kühlvorrichtung (1) gemäß einem der vorhergehenden Ansprüche, **dadurch gekennzeichnet, dass** wenigstens eine Steuervorrichtung (S) vorgesehen ist, um die leitungsgebundenen und/oder feldgebundenen Störungen (S_{xy}) beim Betrieb der Kühlvorrichtung (1) so in ihrer Störcharakteristik zu verändern, dass durch die Überlagerung zweier oder mehrere der veränderten leitungsgebundenen und/oder feldgebundenen Störungen (S_{xy}) eine Störkompensation unterhalb eines definierten Störpegels erfolgt.

## Claims

1. A cooling apparatus (1) comprising a metallic and/or electrically conductive EMC enclosure (2) and a frequency converter (E₁) as well as a plurality of electrically operated units (E_{2,} ..., Eₙ) within the EMC enclosure (2), said electrically operated units (E₂, ..., Eₙ) are formed without power supply and are connected only to said frequency converter (E1) for voltage supply, and wherein said electrically operated units (E₂, ..., Eₙ) are formed to influence a local temperature in at least one region (30, 31) inside or outside said EMC enclosure (2), wherein said frequency converter (E₁) directly supplies at least one or more of said units (E₂, ..., En) with a respective supply voltage, and wherein said frequency converter (E₁) and said units (E₂, ..., En) are respectively formed such that the line-bound and/or field-bound interference (S_{xy}) which is specifically generated by said frequency converter (E₁) or one unit of said units (E₂, ..., En) during operation of said cooling apparatus (1) is compensated by a line-bound and/or field-bound interference (S_{xy}) of at least one of the respective other units (E₁, ..., Eₙ) partially or completely in terms of its respective interference level (Pₙ), **characterized in that** the compensation takes place by means of a destructive interference or superposition, wherein at least one or more of said units (E₂, ..., En) are fans, in particular internal and external fans.

2. The cooling apparatus (1) according to claim 1, **characterized in that** the cooling apparatus is formed so that said at least one fan (E₂, ..., En) is mounted reversibly interchangeably with another fan (E₂, ..., Eₙ) in the cooling apparatus and the respective built-in fan (E₂, ..., En) is supplied directly with a supply voltage from a DC intermediate circuit (GZ) of the frequency converter (E₁).

3. The cooling apparatus (1) according to claim 1, **characterized in that** at least one of said units (E₂, ..., Eₙ) is a refrigerating compressor.

4. The cooling apparatus (1) according to claim 2, **characterized in that** said at least one refrigerating compressor is supplied by a supply voltage of an inverter (W) of said frequency converter (E₁).

5. The cooling apparatus (1) according to any one of the preceding claims, **characterized in that** at least that line-bound and/or field-bound interference (S_{xy}) having the highest interference level (Pn) is compensated that much by at least one line-bound and/or field-bound interference (S_{xy}) of one of said units (E₂, ..., Eₙ) or said frequency converter (E₁) that the resulting interference level (P_{n'}) is below a specific interference immunity level (Pₘₐₓ) of said or said respective other units (E₂, ..., Eₙ).

6. The cooling apparatus (1) according to any one of the preceding claims, **characterized in that** said frequency converter (E₁) and said units (E₂, ..., Eₙ) are chosen such that one or more of the respective interference levels (Pn) of the line-bound and/or or field-bound interferences (S_{xy}) which are generated by said frequency converter (E₁) or said units (E₂, ..., Eₙ) in an isolated single operation, are compensated in the configuration implemented in said cooling apparatus (1) preferably below the interference immunity level (P_{max, n}) of that unit which has the lowest interference immunity level (P_{max, n}) compared to the other units.

7. The cooling apparatus (1) according to any one of the preceding claims, **characterized in that** at least one control apparatus (S) is provided in order to change the line-bound and/or field-bound interferences (S_{xy}) in the operation of said cooling apparatus (1) in terms of their interference characteristics such that an interference compensation below a defined interference level takes place by the superposition of two or more of the changed line-bound and/or field-bound interferences (S_{xy}).

## Revendications

1. Dispositif de refroidissement (1) comprenant un boîtier CEM (2) métallique et/ou électriquement conducteur et un convertisseur de fréquence (E₁) ainsi que plusieurs unités à commande électrique (E₂, ..., Eₙ) à l'intérieur du boîtier CEM (2), qui sont réalisées respectivement sans bloc d'alimentation et qui, en vue de leur alimentation électrique, sont simplement reliées au convertisseur de fréquence (E1), et dans lequel les unités (E₂, ..., Eₙ) sont réalisées de manière à influer sur une température locale dans au moins une région (30, 31) à l'intérieur ou à l'extérieur du boîtier CEM (2), dans lequel le convertisseur de fréquence (E₁) alimente directement au moins une ou plusieurs des unités (E₂, ..., En) avec une tension d'alimentation respective, et dans lequel le convertisseur de fréquence (E₁) et les unités (E₂, ..., En) sont respectivement réalisées de sorte que l'interférence intervenant par conduction et/ou effet de champ (S_{xy}), générée de manière spécifique par le convertisseur de fréquence (E1) ou une unité appartenant aux unités (E₂, ..., En) pendant le fonctionnement du dispositif de refroidissement (1), est partiellement ou totalement compensée à hauteur de son niveau d'interférence (Pn) respectif grâce à une interférence intervenant par conduction et/ou effet de champ (S_{xy}) d'au moins une parmi les autres unités (E₁, ..., En), **caractérisé en ce que** la compensation intervient grâce à une interférence, ou une superposition, destructive, dans lequel au moins une ou plusieurs des unités (E₂, ..., Eₙ) sont des ventilateurs, en particulier des ventilateurs internes et des ventilateurs externes.

2. Dispositif de refroidissement (1) selon la revendication 1, **caractérisé en ce que** le dispositif de refroidissement est réalisé de sorte que l'au moins un ventilateur (E₂, ..., En) est installé au sein du dispositif de refroidissement de manière à pouvoir être échangé de manière réversible par un autre ventilateur (E₂, ..., Eₙ) et le ventilateur (E₂, ..., En) respectivement intégré est alimenté directement avec une tension d'alimentation provenant d'un circuit intermédiaire CC (GZ) du convertisseur de fréquence (E₁).

3. Dispositif de refroidissement (1) selon la revendication 1, **caractérisé en ce qu'**au moins une des unités (E₂, ..., En) est un compresseur frigorifique.

4. Dispositif de refroidissement (1) selon la revendication 2, **caractérisé en ce que** l'au moins un compresseur frigorifique est alimenté par une tension d'alimentation d'un onduleur (W) du convertisseur de fréquence (E₁).

5. Dispositif de refroidissement (1) selon l'une quelconque des revendications précédentes, **caractérisé en ce qu'**au moins l'interférence intervenant par conduction et/ou effet de champ (S_{xy}) qui présente le niveau d'interférence (Pn) le plus élevé est compensée, grâce à au moins une interférence intervenant par conduction et/ou effet de champ (S_{xy}) d'une parmi les autres unités (E₂, ..., Eₙ) ou du convertisseur de fréquence (E₁), si fortement que le niveau d'interférence (P_{n'}) qui en résulte est inférieur à un niveau de résistance aux interférences (Pₘₐₓ) spécifique de l'autre unité (E₂, ..., En) ou des autres unités (E₂, ..., En) respectives.

6. Dispositif de refroidissement (1) selon l'une quelconque des revendications précédentes, **caractérisé en ce que** le convertisseur de fréquence (E₁) et les unités (E₂, ..., En) sont choisis de sorte que, dans la configuration mise en œuvre au sein du dispositif de refroidissement (1), un ou plusieurs parmi les niveaux d'interférence (Pn) respectifs des interférences intervenant par conduction et/ou effet de champ (S_{xy}) que génèrent le convertisseur de fréquence (E₁) ou les unités (E₂, ..., En) pendant un fonctionnement individuel isolé sont compensés de manière préférée sous le niveau de résistance aux interférences (P_{max,n}) de l'unité qui présente comparativement aux autres unités le niveau de résistance aux interférences (P_{max,n}) le plus faible.

7. Dispositif de refroidissement (1) selon l'une quelconque des revendications précédentes, **caractérisé en ce qu'**au moins un dispositif de commande (S) est fourni afin de modifier les caractéristiques d'interférence des interférences intervenant par conduction et/ou effet de champ (S_{xy}) pendant le fonctionnement du dispositif de refroidissement (1) de sorte qu'une compensation d'interférence sous un niveau d'interférence défini intervient grâce à la superposition de deux ou plus de deux parmi les interférences intervenant par conduction et/ou effet de champ (S_{xy}) modifiées.
